# EUROPÄISCHE PATENTANMELDUNG

(11) **EP 1 455 192 A2**
(43) Veröffentlichungstag der Anmeldung: **08.09.2004**
(21) Anmeldenummer: 04002472.1
(22) Anmeldetag: 04.02.2004
(51) Int. Cl.: G01R 23/00

(54) **Verfahren und Vorrichtung zum Messen der Resonanzfrequenz eines Resonanzkreises**

(30) Priorität: 07.03.2003 DE 10310143
(71) Anmelder: Patent-Treuhand-Gesellschaft für elektrische Glühlampen mbH, 81543 München (DE)
(72) Erfinder: Busse, Olaf, 80686 München (DE); Schemmel, Bernhard, 82234 Wessling (DE)

(57) **Zusammenfassung**

Die Bestimmung der Resonanzfrequenz eines Resonanzkreises, insbesondere eines Heizkreises für eine Entladungslampe, soll verbessert werden. Hierzu wird die Frequenz einer Versorgungsspannung für den Resonanzkreis innerhalb eines vorgegebenen Frequenzbereichs variiert. Die Spannung oder der Strom an/in dem Resonanzkreis werden in Abhängigkeit von der variierten Frequenz gemessen. Der vorgegebenen Frequenzbereich wird in beiden Richtungen durchlaufen, wobei jeweils ein Maximum der gemessenen Spannung oder des gemessenen Stroms festgestellt wird. Aus den beiden Maxima wird die Resonanzfrequenz vorzugsweise durch Mittelwertbildung berechnet.

## Beschreibung

### Technisches Gebiet

Die vorliegende Erfindung betrifft ein Verfahren zum Messen der Resonanzfrequenz eines Resonanzkreises, insbesondere eines Heizkreises für eine Entladungslampe, durch Variieren der Frequenz einer Versorgungsspannung für den Resonanzkreis innerhalb eines vorgegebenen Frequenzbereichs und Messen einer Spannung oder eines Stroms an/in dem Resonanzkreis in Abhängigkeit von der variierten Frequenz. Darüber hinaus betrifft die vorliegende Erfindung eine entsprechende Vorrichtung zum Messen der Resonanzfrequenz.

### Stand der Technik

Das Vorheizen einer Entladungslampe erfolgt durch einen Heizkreis, der bei Resonanz betrieben wird. Hierzu muss die Resonanzfrequenz des Heizkreises exakt ermittelt werden. Sie hängt von den Bauteiletoleranzen des Heiztrafos und des Resonanzkreises ab, aber auch vom Wendelwiderstand der angeschlossenen Lampe.

Darüber hinaus wird bei der Ermittlung der Resonanzfrequenz der maximale Strom beziehungsweise die maximale Spannung, der/die bei Resonanz auftreten, gemessen. Aus diesem Maximalwert kann der angeschlossene Lampentyp erkannt werden. Eine genaue Messung der Resonanzfrequenz ist daher nicht nur für eine gute Vorheizung, sondern auch für eine zuverlässige Lampenerkennung zwingend erforderlich.

Die Messung des Maximums mittels eines A/D-Wandlers wird bei Schaltnetzteilen, wie z. B. EVGs, durch viele Störeinflüsse erschwert. Mittels eines optimierten Platinen-Layouts lassen sich diese Störungen zwar verringern, sie bleiben aber dennoch vorhanden und führen dazu, dass das gemessene Maximum nicht mit dem realen Maximum übereinstimmt.

Bei bekannten Verfahren für die Messung der Resonanzfrequenz wird der Frequenzbereich, in dem die Resonanzfrequenz zu erwarten ist, einmal durchfahren und das Maximum einer Messspannung ermittelt. Anschließend wird der Frequenzwert, bei dem das Maximum gemessen wurde, für die Vorheizung verwendet. Um systematische Störungen auszugleichen, wird nach dem bekannten Verfahren ein fester Offset-Wert zur ermittelten Frequenz addiert beziehungsweise von dieser subtrahiert. Systematische Fehler ergeben sich beispielsweise aus der Filtercharakteristik des Messpfads und aus dem unterschiedlichen Verhalten des Resonanzkreises oberhalb und unterhalb der Resonanzfrequenz.

Ein derartiges Verfahren ist aus der deutschen Offenlegungsschrift DE 100 13 342 A1 bekannt. Zur Erzeugung einer Zündspannung für Leuchtstofflampen wird die Wechselspannung einem LC-Reihenschwingkreis über ein erstes Zeitintervall mit einer ersten Startfrequenz aufgeprägt. Nach dem ersten Zeitintervall wird die Spannung an der Leuchtstofflampe gemessen und mit einem Sollwert verglichen. Bei Erreichen des Sollwerts erfolgt ein Abbruch der Zündspannungserzeugung, wobei eine Spannung zum Normalbetrieb der Leuchtstofflampe angelegt wird. Diese Verfahrensschritte werden für ein n-tes Zeitintervall mit einer n-ten Startfrequenz wiederholt, bis der Sollwert erreicht wird. Dabei entspricht die erste Startfrequenz einem durch die Toleranz der beteiligten Bauelemente bedingten größtmöglichen Wert der Resonanzfrequenz. Die m-te Startfrequenz entspricht einem durch die Toleranz der beteiligten Bauelemente bedingten kleinstmöglichen Wert der Resonanzfrequenz. Jede n-te Startfrequenz ist kleiner als ihre vorhergehende Startfrequenz. Durch eine Variation der Startfrequenzen der Wechselspannung, die an den LC-Reihenschwingkreis angelegt wird, wird der mögliche Toleranzbereich der Resonanzfrequenz "durchfahren", bis der erforderliche Wert einer Zündspannung für die Leuchtstofflampe erreicht wird. Damit wird es vermieden, dass infolge fehlender Resonanz eine zu geringe Zündspannung entsteht und die Lampe nicht zündet. Wie oben bereits erwähnt, ist dieses Ermitteln der Resonanzfrequenz beim Durchfahren des Frequenzbereichs verhältnismäßig ungenau.

### Darstellung der Erfindung

Die Aufgabe der vorliegenden Erfindung besteht somit darin, eine exaktere Bestimmung der Resonanzfrequenz für den Vorheizkreis einer Entladungslampe zu ermöglichen.

Erfindungsgemäß wird diese Aufgabe gelöst durch ein Verfahren zum Messen der Resonanzfrequenz eines Resonanzkreises, insbesondere eines Heizkreises für eine Entladungslampe, durch Variieren der Frequenz einer Versorgungsspannung für den Resonanzkreis innerhalb eines vorgegebenen Frequenzbereichs und Messen einer Spannung oder eines Stroms an/in dem Resonanzkreis in Abhängigkeit von der variierten Frequenz, wobei der vorgegebene Frequenzbereich in beiden Richtungen durchlaufen, dabei jeweils ein Maximum der gemessenen Spannung oder des gemessenen Stroms festgestellt und aus den beiden Maxima die Resonanzfrequenz ermittelt wird.

Ferner ist erfindungsgemäß vorgesehen eine entsprechende Vorrichtung zum Messen der Resonanzfrequenz eines Resonanzkreises, insbesondere eines Heizkreises für eine Entladungslampe, durch eine Versorgungseinrichtung zum Versorgen des Resonanzkreises mit einer Versorgungsspannung, deren Frequenz innerhalb eines vorgegebenen Frequenzbereichs variierbar ist und einer Messeinrichtung zum Messen einer Spannung oder eines Stroms an/in dem Resonanzkreis in Abhängigkeit von einer Frequenz, wobei die Frequenz der Versorgungsspannung in dem vorgegebenen Frequenzbereich mindestens einmal in beiden Richtungen durchfahrbar und dabei jeweils ein Maximum der Spannung oder des Stroms messbar ist und mit Hilfe einer Bestimmungseinrichtung aus den beiden Maxima die Resonanzfrequenz ermittelbar ist.

Durch das Durchfahren des Frequenzbereichs in beiden Richtungen können systematische Fehler bei der Bestimmung der Resonanzfrequenz minimiert werden. Systematische Fehler resultieren dann nur noch aus der Schrittweite der Frequenzänderung beim Durchfahren des Frequenzbereichs.

Wird der Frequenzbereich der Wechselspannung für das Vorheizen beginnend von einer höchsten Frequenz zu einer niedrigsten, oder umgekehrt, und anschließend wieder zurück durchfahren, so kann die Bestimmung der Maxima in einem Messvorgang erfolgen.

Vorzugsweise wird die Resonanzfrequenz dadurch ermittelt, dass aus den beiden Frequenzen, bei denen jeweils ein Maximum festgestellt wird, ein Mittelwert gebildet wird und dieser als die tatsächliche Resonanzfrequenz interpretiert wird. Um die Sicherheit bei der Bestimmung der Resonanzfrequenz zu erhöhen, können noch mehr Maxima bei mehreren Durchläufen des Frequenzbereichs ermittelt und daraus wiederum der Mittelwert gebildet werden.

Ein Maximum kann dadurch ermittelt werden, dass ein Messwert gespeichert wird, wenn dieser höher ist als der vorhergehende. Dadurch lässt sich auf verhältnismäßig einfache Weise mit beliebiger Genauigkeit, abhängig von der Größe der Frequenzschritte, ein Maximum ermitteln.

### Kurze Beschreibung der Zeichnungen

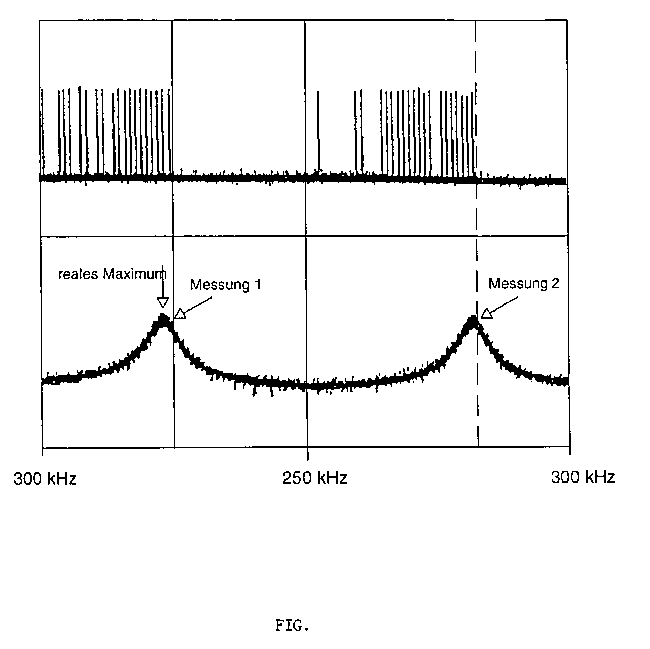

Die vorliegende Erfindung wird nun anhand der beigefügten Zeichnung näher erläutert, die Messsignale zur Ermittlung der Maxima zeigt.

### Bevorzugte Ausführung der Erfindung

Die nachfolgend beschriebene Ausführungsform stellt ein bevorzugtes Ausführungsbeispiel der vorliegenden Erfindung dar.

Erfindungsgemäß wird der Frequenzbereich des Resonanzkreises, in dem die Resonanzfrequenz erwartet wird, beginnend von der höchsten Frequenz, z. B. 300 kHz, bis zur niedrigsten Frequenz, z. B. 250 kHz, und anschließend zurück zur höchsten Frequenz durchfahren. Dies ist mit der Messkurve im unteren Teil der Figur dargestellt. Die Messkurve stellt den zeitlichen Messverlauf dar. Dabei wird die Frequenz mit einer vorgegebenen Geschwindigkeit bis zur Mitte der Zeichnung hin reduziert und anschließend wieder erhöht. In beiden Messabschnitten wird das reale Maximum durchlaufen.

Um das Maximum messtechnisch zu ermitteln wird ein Messwert aufgezeichnet, wenn er höher ist als ein vorhergehender Messwert. Das Signal in der oberen Hälfte der Figur zeigt diesen Vorgang des Abspeicherns. Bei jeder Spitze erfolgt eine Abspeicherung. Da das Signal (siehe untere Hälfte der Figur) verrauscht ist, ist der Abstand der Speichervorgänge teilweise unregelmäßig, obwohl das ideale Signal zunächst kontinuierlich in der ersten Messphase steigt. Das Maximum ergibt sich durch den letzten abgespeicherten Wert. Beim ersten Messdurchlauf ist dieser Wert durch eine vertikale Linie (Messung 1) gekennzeichnet. Aus der Zeichnung wird deutlich, dass der so bestimmte Messwert bezogen auf die Frequenz unterhalb des realen Maximums liegt.

In der anschließenden zweiten Messphase, bei der die Frequenz wieder schrittweise gesteigert wird, steigt die Amplitude des Messsignals zunächst ebenfalls an. Dies wird auch aus dem darüber liegenden Signal deutlich. Die Spitzen zeigen auch hier diejenigen Zeitpunkte an, an denen ein höherer Messwert abgespeichert wird. Die zweite Messung führt zu einem Frequenzwert, der in der Zeichnung durch einen gestrichelten vertikalen Strich angedeutet ist und der oberhalb des realen Maximums liegt.

Zur Auswertung des Messergebnisses werden die beiden Messwerte von Messung 1 und Messung 2 gemittelt, so dass sich ein mittleres, rechnerisches Maximum ergibt. Dieses rechnerische Maximum liegt mit hoher Wahrscheinlichkeit sehr nahe am realen Maximum.

Durch die Mittelwertbildung der beiden Maxima werden die oben erwähnten Störeinflüsse weitestgehend ausgeblendet, so dass das berechnete Mittel sehr nahe am realen Maximum liegt.

## Patentansprüche

1. Verfahren zum Messen der Resonanzfrequenz eines Resonanzkreises, insbesondere eines Heizkreises für eine Entladungslampe, durch
Variieren der Frequenz einer Versorgungsspannung für den Resonanzkreis innerhalb eines vorgegebenen Frequenzbereichs und
Messen einer Spannung oder eines Stroms an/in dem Resonanzkreis in Abhängigkeit von der variierten Frequenz,
**dadurch gekennzeichnet, dass**
der vorgegebene Frequenzbereich in beiden Richtungen durchlaufen, dabei jeweils ein Maximum der gemessenen Spannung oder des gemessenen Stroms festgestellt und aus den beiden Maxima die Resonanzfrequenz ermittelt wird.

2. Verfahren nach Anspruch 1, wobei der Frequenzbereich beim Variieren der Frequenz der Versorgungsspannung beginnend von der höchsten Frequenz zur niedrigsten, oder umgekehrt, und anschließend wieder zurück durchfahren wird.

3. Verfahren nach Anspruch 1 oder 2, wobei die Resonanzfrequenz durch Bildung des Mittelwerts der beiden Frequenzen, bei denen jeweils ein Maximum festgestellt wird, ermittelt wird.

4. Verfahren nach einem der Ansprüche 1 bis 3, wobei ein Maximum durch Speichern eines Messwerts, wenn dieser höher ist als der vorhergehende, ermittelt wird.

5. Vorrichtung zum Messen der Resonanzfrequenz eines Resonanzkreises, insbesondere eines Heizkreises für eine Entladungslampe, mit
einer Versorgungseinrichtung zum Versorgen des Resonanzkreises mit einer Versorgungsspannung, deren Frequenz innerhalb eines vorgegebenen Frequenzbereichs variierbar ist und
einer Messeinrichtung zum Messen einer Spannung oder eines Stroms an/in dem Resonanzkreis in Abhängigkeit von einer Frequenz,
**dadurch gekennzeichnet, dass**
die Frequenz der Versorgungsspannung in dem vorgegebenen Frequenzbereich mindestens einmal in beiden Richtungen durchfahrbar und dabei jeweils ein Maximum der Spannung oder des Stroms messbar ist und
mit Hilfe einer Bestimmungseinrichtung aus den beiden Maxima die Resonanzfrequenz ermittelbar ist.

6. Vorrichtung nach Anspruch 5, wobei mit der Versorgungseinrichtung der Frequenzbereich der Versorgungsspannung beginnend von der höchsten Frequenz zur niedrigsten, oder umgekehrt, und anschließend wieder zurück durchfahrbar ist.

7. Vorrichtung nach Anspruch 5 oder 6, wobei mit Hilfe der Bestimmungseinrichtung ein Mittelwert der beiden Frequenzen, bei denen jeweils ein Maximum festgestellt ist, als Resonanzfrequenz bestimmbar ist.

8. Vorrichtung nach einem der Ansprüche 5 bis 7, wobei die Messeinrichtung eine Speichereinrichtung umfasst, mit der zur Ermittlung eines Maximums ein Messwert speicherbar ist, wenn dieser höher ist als der vorhergehende.
